# EUROPEAN PATENT SPECIFICATION

(11) **EP 0 508 552 B1**
(45) Date of publication and mention of the grant of the patent: **10.12.1997**
(21) Application number: 92201954.2
(22) Date of filing: 24.10.1988
(51) Int. Cl.: G11C 7/00, G11C 16/06, G11C 17/18

(54) **Programmable semiconductor memory**
Programmierbarer Halbleiterspeicher
Mémoire à semi-conducteurs programmable

(43) Date of publication of application: 14.10.1992
(62) Divisional of application: 88309994.7
(73) Proprietor: KABUSHIKI KAISHA TOSHIBA, Kawasaki-shi, Kanagawa-ken 210 (JP)
(72) Inventor: Masuoka, Fujio, c/o Patent Division, Minato-ku, Tokyo (JP)
(74) Representative: Maury, Richard Philip

(56) References cited:
- EP-A- 0 179 605
- EP-A- 0 283 230
- IBM TECHNICAL DISCLOSURE BULLETIN. vol. 27, no. 6, November 1984, NEW YORK US pages 3302 - 3306 ADLER 'DENSELY ARRAYED EEPROM HAVING LOW-VOLTAGE TUNNEL WRITE'
- PATENT ABSTRACTS OF JAPAN vol. 9, no. 28 January 1985 & JP-A-59 152 592
- PATENT ABSTRACTS OF JAPAN vol. 6, no. 8 (P-98)(886) 19 January 1982 & JP-A-56 134 390
- HITACHI REVIEW vol. 35, no. 5, October 1986, TOKYO JP pages 263 - 266 FUKUDA E. A. '1 MBIT CMOS EPROM: HN27C101 AND HN27C301'

## Description

This application is related by subject matter to EP-A-0 365 721 entitled "Programmable Semiconductor Memory" filed concurrently herewith. This application is divided from EP-A-365 720.

This invention is applicable to a programmable semiconductor memory using non-volatile transistors as memory cells from which data can be electrically erased. It particularly but not exclusively relates to a non-volatile semiconductor memory in which data stored in a plurality of memory cells may be erased simultaneously, in units of a block, or in units of a column. Data may be written to the memory a cell (or bit) at a time.

A non-volatile transistor memory which permits erasure of data is known as an EPROM (Erasable and Programmable Read Only Memory). An EPROM from which data may be erased electrically is called an E² PROM (Electrically Erasable PROM). E² PROMs have been developed which permit the simultaneous erasure of data stored in a plurality of memory cells. Such an E² PROM is disclosed in "A 128K Flash EEPROM Using Double Polysilicon Technology", pp. 76-77 of "1987 IEEE International Solid State Circuits Conference, Digest of Technical Papers."

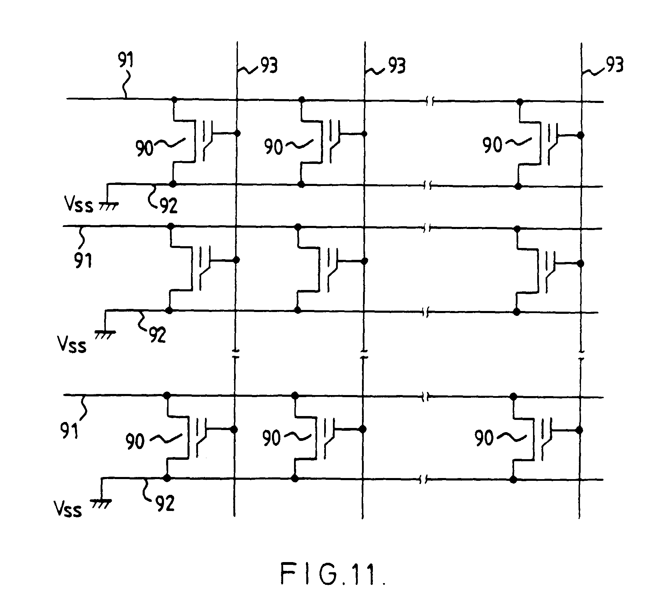

Figure 11 is a circuit diagram depicting a conventional E² PROM memory cell array using the cells described in the above-mentioned document. In this Figure, memory cells 90 consist of non-volatile transistors having a floating gate electrode and a control gate electrode. Data erasure may be effected electrically. Memory cells 90 are arranged in a row and column matrix. The drains of each memory cell 90 in a given row of memory cells (which are horizontal as seen in the drawing) are respectively coupled to the same one of bit lines 91. The sources of the memory cells 90 in a given row of memory cells are respectively coupled to the same one of ground lines 92. The control gate electrodes of the memory cells 90 in a given column of memory cells (which are vertical as seen in the drawing) are respectively coupled to the same one of column lines 93. In this memory, data may be read or written by the selective imposition of set voltages on a given bit line 91 and column line 93 to select a particular 1-bit cell. Block data erasure of all the bits can be effected by the simultaneous imposition of a set voltage on all the bit lines 91.

This memory permits large-scale integration of cells since each cell or bit consists of a single non-volatile transistor. However, data erasure may only be effected in the cells simultaneously or in units of a row. It is not possible to effect data erasure in units of a byte, the processing unit for parallel read/write memories.

The prior art does disclose an E² PROM which permits data erasure in byte units. Reference is made, for example to "A Million-cycle CMOS 256K EEPROM", pp. 78-79 of "1987 IEEE International Solid-State Circuits Conference, Digest of Technical Papers." However, large-scale integration of cells is not possible with the memory disclosed therein, since each 1-bit memory cell comprises two or four transistors.

A device for reading data or writing data in a high speed from or to a memory array by dividing a data line selection circuit into two stages and sense amplifiers and temporary storage cells arranged at the output side of the first stage of the data line selection circuit is known from PAJ vol. 9, no. 2, 8 Jan 1985, & JP-A-59152592.

A memory having circuit units each comprising a plurality of series connected memory cells is known from IBM TDB vol. 27, no. 6, Nov. 1984, p. 3302-3307.

According to the invention, there is provided a data read/write device as defined in Claim 1; and a method of reading/writing as defined in Claims 12 and 13. It is an advantage of the described embodiment of the invention that a device to control the operations of a programmable semiconductor memory wherein the reading, writing and electrical erasure of data is effected in 8 bit (1 byte) units is provided.

Another advantage is that a progammable semiconductor memory wherein a high integration density can be achieved by reducing the number of wires and the number of contact is provided.

Another advantage is that a programmable semiconductor memory is provided wherein the reading, writing, and electrical erasure of data in 8 bit (1 byte) units can be achieved).

Yet another advantage is that a programmable semiconductor memory with high integration density is provided wherein the electrical data erasure is made in byte units.

A further advantage is that a programmable semiconductor memory is provided whose manufacturing cost is low.

An embodiment of the invention will now be described, by way of example, with reference to the accompanying drawings, in which:
Figure 1 is a circuit diagram showing the entire configuration, including peripheral circuitry, of an embodiment of an E² PROM according to the present invention.
Figure 2 is a circuit diagram showing the detailed configuration of the column decoder/input-output circuit depicted in Figure 1.
Figure 3 is a circuit diagram showing the detailed configuration of the latch circuit depicted in Figure 2.
Figure 4 is a circuit diagram showing the detailed configuration of the sense amplifier depicted in Figure 2.
Figure 5 is a circuit diagram showing the detailed configuration of the data input buffer depicted in Figure 2.
Figure 6 is a circuit diagram showing the detailed configuration of a portion of the selector circuit depicted in Figure 2.
Figure 7 is a table showing the address inputs to the partial selectors of the selector circuit depicted in Figure 2.
Figures 8A and 8B are timing charts associated with writing data to the E² PROM depicted in Figure 1.
Figures 9A and 9B are timing charts associated with reading data from the E² PROM depicted in Figure 1.
Figure 10 is a timing chart associated with erasing data from the E² PROM depicted in Figure 1.
Figure 11 is a circuit diagram of a prior art non-volatile semiconductor memory.
Figure 12 is the circuit diagram of Figure 1 without the associated peripheral circuitry.
Figure 13 is a plan view of a pattern showing the memory cell array of the circuit diagram corresponding to Figure 12.
Figures 14, 15 and 16 are cross-sectional views taken along lines I-I', II-II', and III-III' of Figure 13 respectively.
Figures 17 and 18 are cross-sectional views showing the non-volatile transistors provided with a floating gate electrode and a control gate electrode.

### DETAILED DESCRIPTION OF THE PREFERRED EMBODIMENT

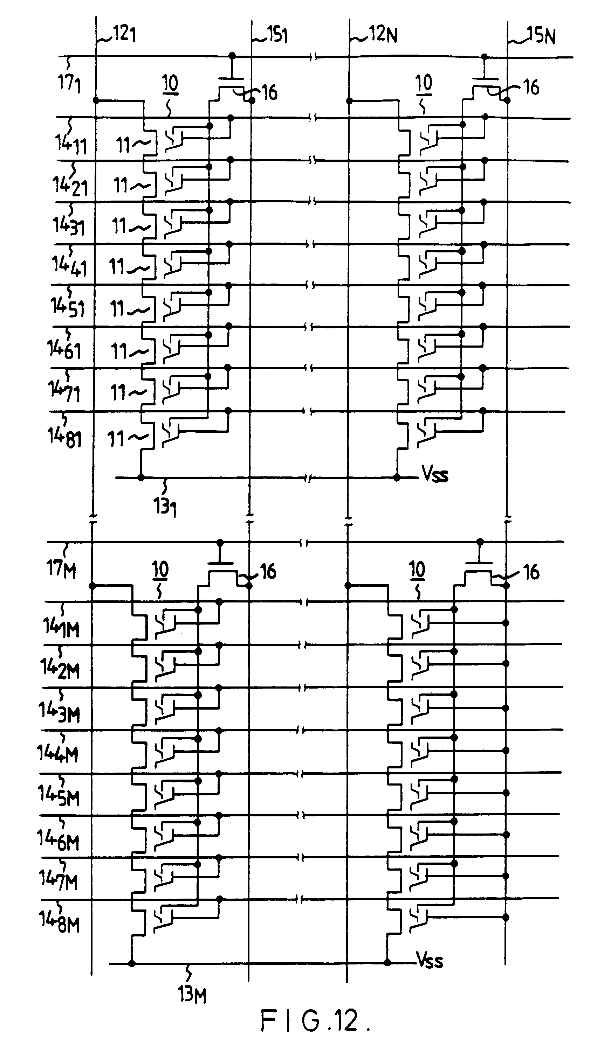

Figure 12 is a circuit diagram of a memory cell array portion in which the present invention is applied to an E² PROM (referred to below simply as a "memory"). In the drawing, series circuit units 10 each include eight memory cells 11 connected in series. Each memory cell 11 in each series circuit unit 10 includes a non-volatile transistor having: a source region; a drain region; a floating gate electrode provided in the channel region between the source and drain regions; an erase gate electrode; and a control gate electrode, the latter two gate electrodes arranged so as to overlap the floating gate electrode.

Generally, the present invention may be applied to what may be termed programmable memories. Programmable memory as used herein refers to any kind of semiconductor memory which can be programmed after fabrication or manufacture. It may include, but should not be limited to, non-volatile memories. SRAMs, and DRAMs.

A plurality of these series circuit units 10 are arranged in a matrix fashion. The series circuit units are disposed in rows and columns. As used herein "row" refers to that which extends horizontally or from left to right as viewed in Figure 12. "Column" refers to that which extends vertically or from top to bottom as viewed in Figure 12. For clarity in the subsequent discussion, it should be noted that each row of series circuit units in Figure 12 includes eight rows of memory cells, the control gates of the memory cells disposed in a given row of memory cells being coupled to the same one of row lines 14. Although these terms have been defined for clarity of description, they should not be read to limit in any way the scope of the invention, but rather to facilitate understanding.

Each series circuit unit 10 has one end coupled to one of bit lines 12₁,...12_{N}, with each of the series circuit units in a given column of series circuit units being coupled to the same bit line. The other end of each series circuit unit 10 is coupled to one of ground lines 13₁,...13_{N}, with each of the series circuit units in a given row of series circuit units being coupled to the same ground line. A potential difference of 0 V is maintained across each of the ground lines 13. The control gate electrodes of each of the eight memory cells 11 in a series circuit unit 10 are coupled to a respective one of row lines 14. Each row of series circuit units has associated with it eight row lines 14₁...14₈, with the memory cells in a given row of memory cells being coupled to the same row line. In each series circuit unit 10, the erase gate electrodes of the eight memory cells 11 are connected to each other. These connected erase gate electrodes are coupled to one of erase lines 15₁,...15_{N} through a switching transistor 16. The series circuit units in a given column of series circuit units are coupled to the same erase line through switching transistors, a single switching transistor being provided for each series circuit unit. The control gate electrodes of the switching transistors 16 are coupled to one of erase selection lines 17₁,...17_{M}, with the control gate electrodes of the switching transistors in a given row of series circuit units being coupled to the same erase selection line.

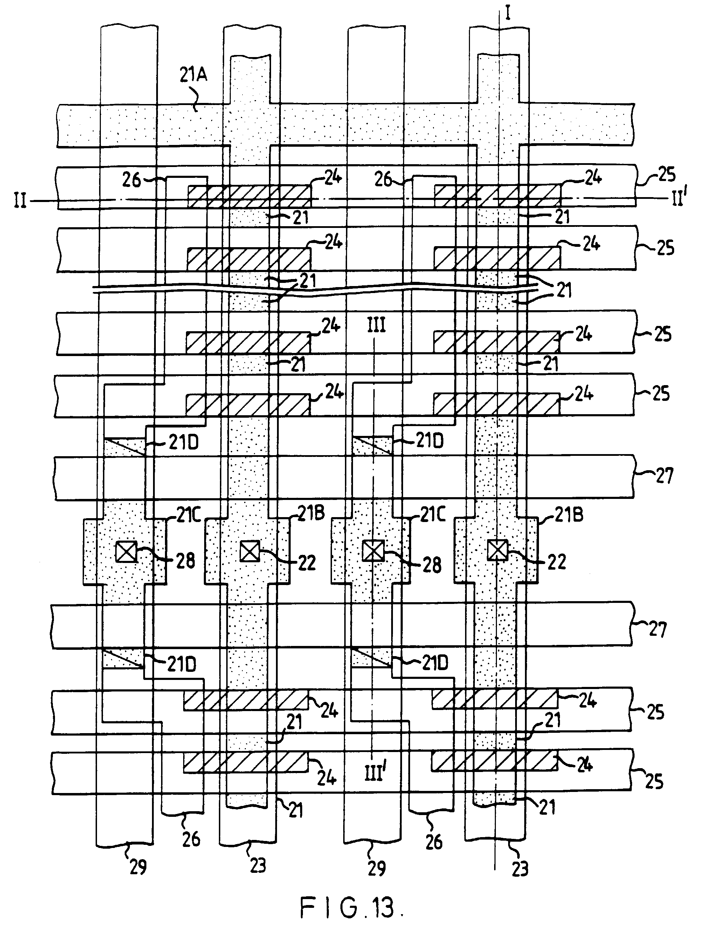

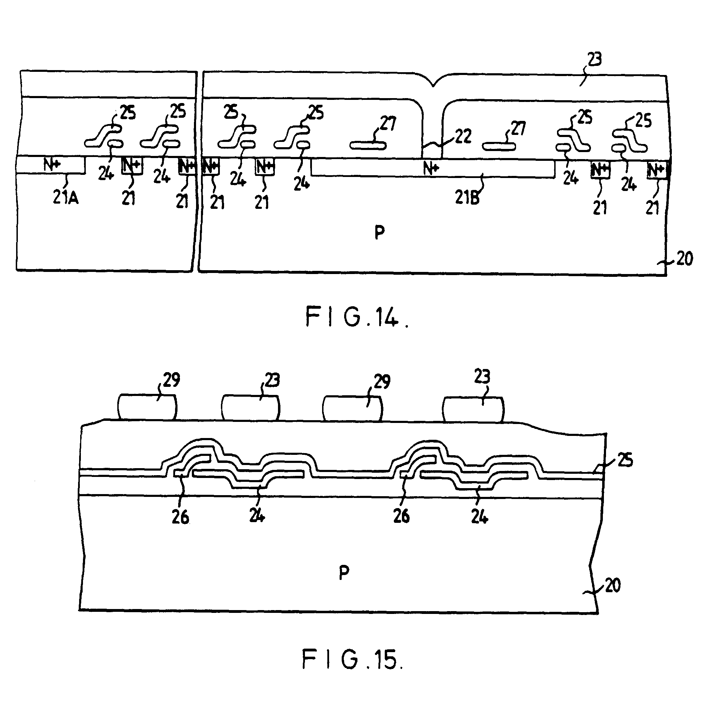

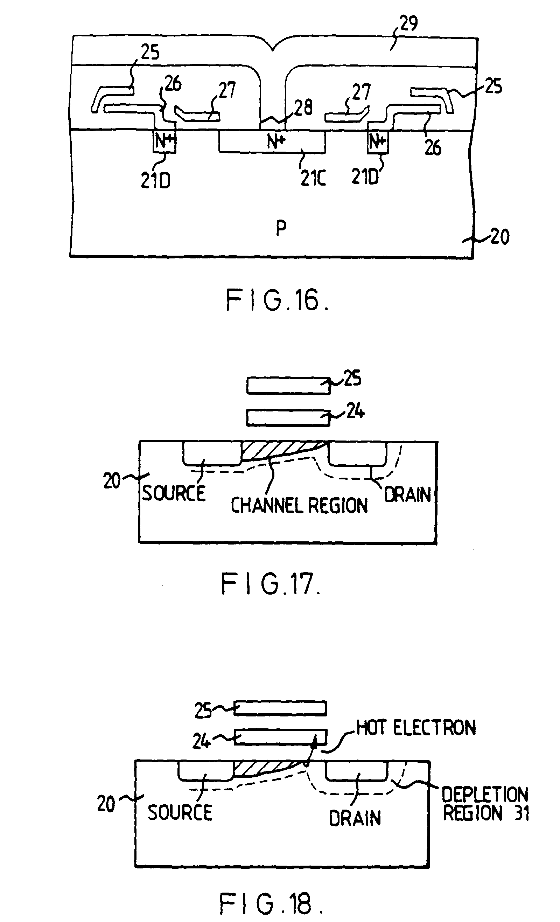

Figure 13 is a plan view corresponding to the structure of the memory cell array circuit shown in Figure 12 when such a memory is actually provided on a semiconductor chip. Figure 14 is a cross-sectional view along the line I-I' in Figure 13. Figure 15 is a cross-sectional view along the line II-II' in Figure 13. Figure 16 is a cross-sectional view along the line III-III' in Figure 13.

A P-type silicon semiconductor substrate is used as the substrate 20 in the memory of this embodiment. Separate N⁺ type regions 21, providing the source and drain regions of the eight memory cells 11 in each series circuit unit 10, are formed in the surface region of the substrate 20. N⁺ regions 21A and 21B, positioned in the uppermost and central portions of Figure 13 respectively, are common to neighboring series circuit units 10. N⁺ region 21A serves as a ground line 13. Metal leads 23, made for example of aluminium, are connected to N⁺ regions 21B through contact holes 22 and serve as the bit lines 12. Electrodes 24, made of a first polycrystalline silicon layer and put in a floating electrical state, are formed between adjacent N⁺ regions 21, insulated therefrom by an insulating layer. Electrodes 24 are the floating gate electrodes of the various memory cells 11. Electrodes 25, made of a third polycrystalline silicon layer, are formed over the sets of electrodes 24 that are disposed horizontally in Figure 13, insulated therefrom by an insulating layer. Electrodes 25 are the control gate electrodes of the memory cell 11 and serve as the column lines 14. Electrodes 26, made of a second polycrystalline silicon layer, are formed between adjacent series circuits disposed in different columns, and partially overlap electrodes 24, insulated therefrom by an insulating layer. Electrodes 26 are the common erase gate electrodes of the various memory cells 11 in the series circuit units.

N⁺ regions 21C are formed between adjacent N⁺ regions 21B. A pair of N⁺ regions 21D are also formed separate from N⁺ regions 21C. N⁺ regions 21C and 21D are the source and drain regions of switching transistor 16. Electrodes 27, made of the third polycrystalline silicon layer, are formed between these source and drain regions, insulated therefrom by an insulating layer. Electrodes 27 are the control gate electrodes of transistors 16 and serve as the erase selection lines 17. Electrodes 26, the common erase gate electrodes, are connected to N⁺ regions 21D via a direct contact portion and metal leads 29, of, for example, aluminum, are connected to N⁺ regions 21C via contact holes 28. Metal leads 29 serve as erase lines 15.

Thus, the memory is a matrix of series circuit units 10, each of which comprises eight series connected memory cells 11. One end each of each series circuit unit 10 is connected to a bit line 12, embodied in metal lead 23, and the other end is connected to a ground line 13, embodied in N⁺ region 21A. The control gate electrodes of the various memory cells 11 are connected to row lines 14, embodied in electrodes 25. The erase gate electrodes of each memory cell in a series circuit unit are commonly connected and coupled to erase lines 15 via transistors 16. The conduction of transistors 16 is controlled by signals from the corresponding erase selection line 17.

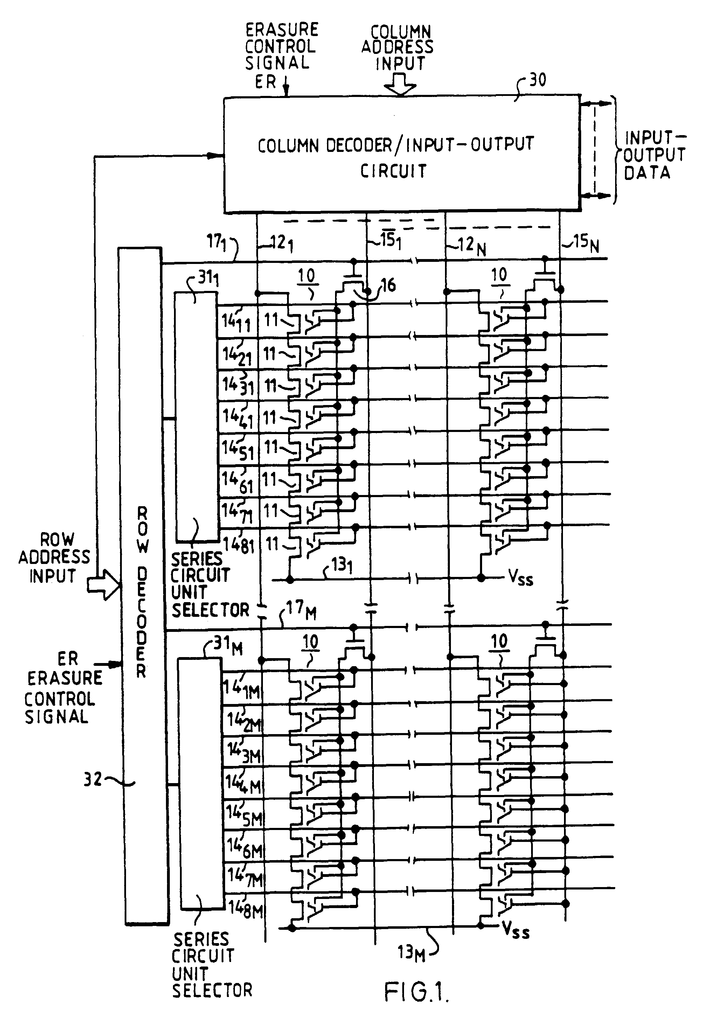

Figure 1 is a diagram showing the overall configuration of an E² PROM according to one embodiment of the present invention. N bit lines 12 and N erase lines 15 are coupled to column decoder/input-output circuit 30 to which an erase control signal ER and a column address input are input. Parts of the row address inputs, discussed later, are input to column decoder/input-output circuit 30, and 8-bit input/output data is input to and output from circuit 30. The detailed configuration of column decoder/input-output circuit 30 will be described below.

Eight row lines 14 are coupled to each of the series circuit unit selectors 31₁ to 31_{M}. Series circuit unit selectors 31 and M erase selection lines 17 are coupled to row decoder 32, to which row address input and erase control signal ER are input. Row decoder 32 outputs a selection signal to one series circuit unit selector 31 in response to a row address input, and selectively outputs a high voltage to one of M erase selection lines 17 in response to row address input during data erasure.

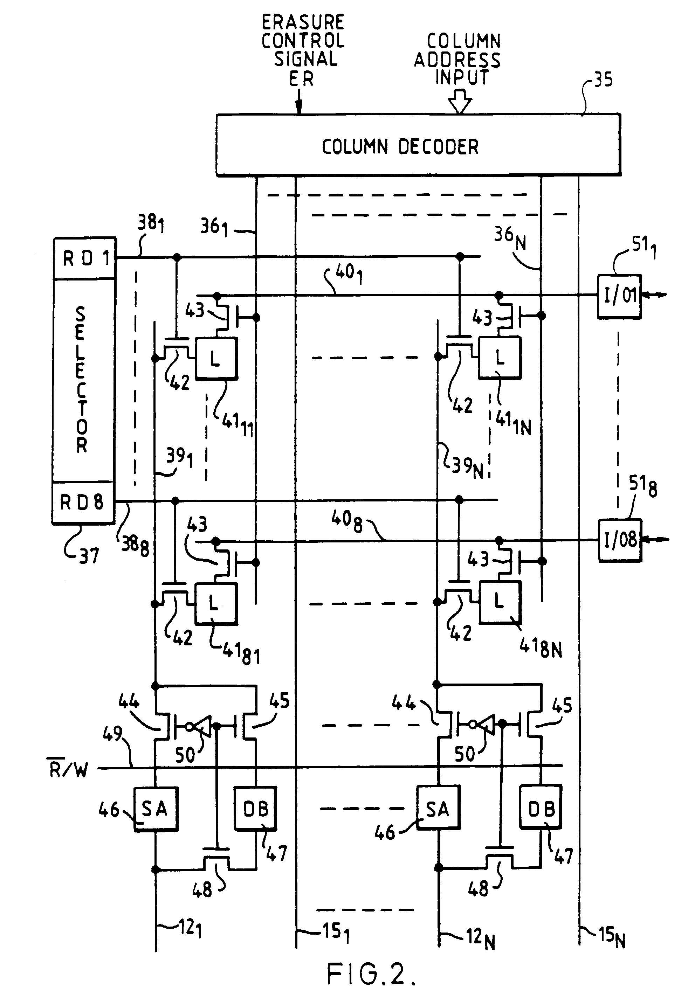

Figure 2 is a circuit diagram showing the internal configuration of column decoder/input-output circuit 30. In Figure 2, reference numeral 35 denotes a column decoder to which a column address input and an erase control signal ER are input. Erase lines 15₁ to 15_{N} and control lines 36₁ to 36_{N} are coupled to column decoder 35. Column decoder 35 selects one of control lines 36₁ to 36_{N} in response to the column address input during data writing and data reading and outputs a high voltage thereto. Decoder 35 selects one of erase lines 15₁ to 15_{N} during data erasure and similarly outputs a high voltage thereto.

Reference numeral 37 denotes a selector, to which parts of the row address inputs (e.g., 3-bit addresses A₁, A₂, A₃) are input. Selector 37 has eight partial selectors RD1 - RD8 and selects one of control lines 38₁ to 38_{N} according to an input address, setting it to a high potential.

Reference numerals 39₁ to 39_{N} denote first data lines, and reference numerals 40₁ to 40₈ denote second data lines. Latch circuits 41₁₁,.., 41_{1N} to 41₈₁,.., 41_{8N} for latching 1-bit data are provided at the respective intersections of the first and second data lines. The eight latch circuits disposed in a given column are coupled to the same first data line 39 through respective data transfer MOS transistors 42, a single transistor 42 being associated with each latch circuit 41. The N latch circuits disposed in a given row are coupled to the same second data line 40 through respective data transfer MOS transistors 43, a single transistor 43 being associated with each latch circuit 41. The gates of the N transistors 42 disposed in the same row are coupled to the corresponding one of control lines 38₁ to 38₈ and the gates of the eight transistors 43 disposed in the same column are coupled to the corresponding one of control lines 36₁ to 36_{N}.

Associated with each first data line 39 are two additional data transfer MOS transistors 44, 45. One terminal of both transistors 44, 45 is coupled to the associated data line 39. The remaining terminal of transistor 44 is coupled to the corresponding one of the bit lines 12₁ to 12_{N} through a sense amplifier 46 while the remaining terminal of transistor 45 is coupled to the corresponding bit line through data input buffer (DB) 47 and data transfer MOS transistor 48, respectively. The gates of MOS transistors 45, 48 are coupled to control line 49, to which a read/write control signal R/W, set to a low potential during data reading and to a high potential during data writing, is applied. The gates of MOS transistors 44 are coupled to control line 49 through inverters 50, respectively. Data input/output circuits (I/01 to I/08) 51₁ to 51₈ are coupled to second data lines 40₁ to 40₈, respectively.

In the column decoder/input-output circuit 30 configured as described above, eight latch circuits 41 are provided for each of the N bit lines 12. A sense amplifier 46 and a data input buffer (DB) 47 are also provided for each bit line 12. The MOS transistors are all N-type.

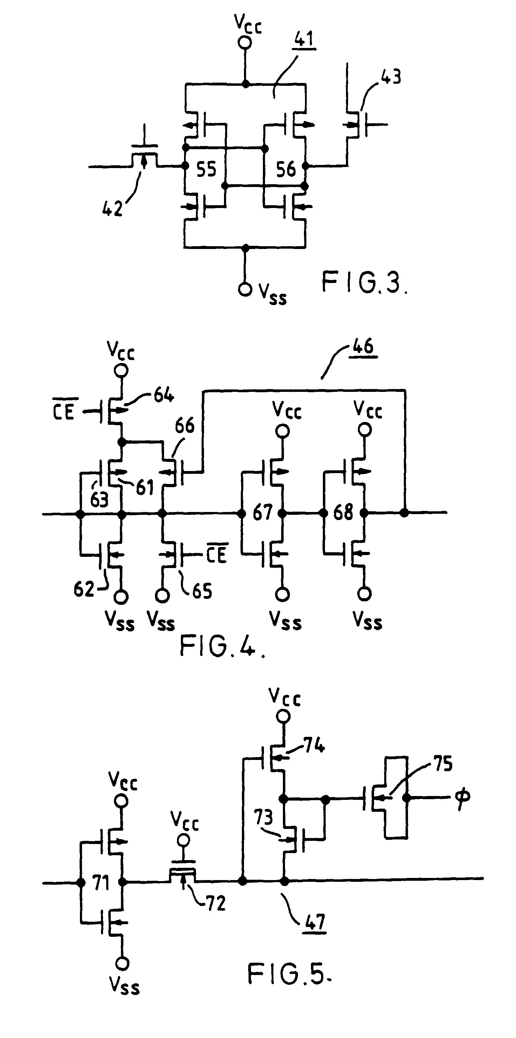

Figure 3 is a circuit diagram showing the detailed configuration of a latch circuit 41 schematically shown in Figure 2. Latch circuit 41 is formed by cross-connecting the input and the output terminals of two CMOS inverters 55 and 56, each inverter having P-type and N-type MOS transistors. One terminal of the data transfer MOS transistors 42 is coupled to the output terminal of inverters 55 and one terminal of data transfer MOS transistors 43 is coupled to the output terminal of inverters 56.

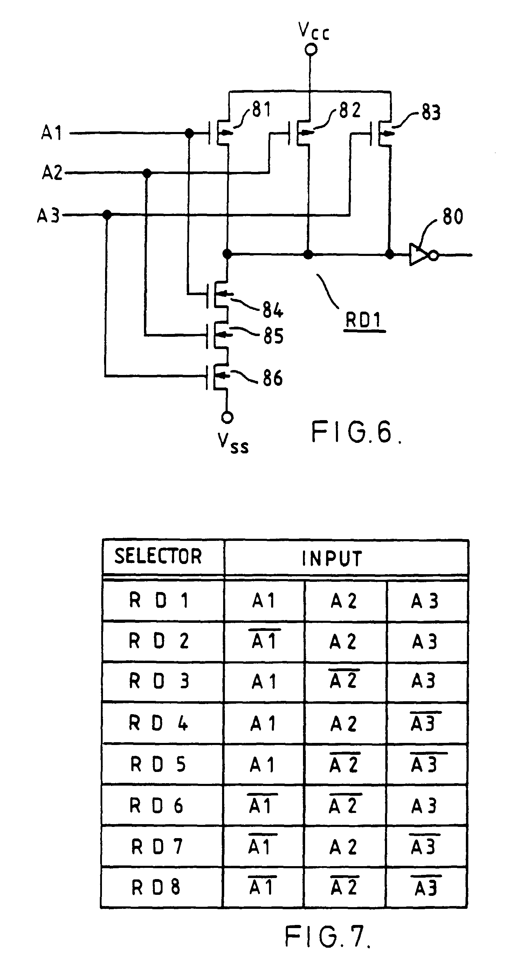

Figure 4 is a circuit diagram showing the detailed configuration of sense amplifier 46 schematically shown in Figure 2. Sense amplifier 46 may be activated by a chip enable control signal CE and includes a CMOS inverter 63 having a P-type MOS transistor 61 and an N-type MOS transistor 62 arranged such that the input and output terminals of the inverter are shortcircuited. P-type MOS transistor 64 is coupled between inverter 63 and power source Vcc and chip enable control signal CE is input to the gate thereof. N-channel MOS transistor 65 is coupled between the output terminal of CMOS inverter 63 and reference power source Vss and chip enable control signal CE is input to the gate thereof. P-type MOS transistor 66 is coupled between the output of CMOS inverter 63 and a junction between inverter 63 and MOS transistor 64. Two CMOS inverters 67, 68 are coupled in cascade to the output of inverter 63. The output of inverter 68 is transmitted as a sense amplifier output to corresponding data line 39 through MOS transistor 44 (Figure 2), and is also fed back to the gate of MOS transistor 66.

The sense amplifier configured as described above is activated in such a manner that transistor 64 is turned on and transistor 65 is turned off when chip enable control signal CE is set to a low-level potential in order to amplify the potential of co-responding bit line 12. Since the input and output terminals of CMOS inverter 63 are shortcircuited, its input terminal potential, i.e., the bit line potential is set, for example, to 1 V when Vcc is, for example, 5 V.

Figure 5 is a circuit diagram showing the detailed configuration of the data input buffer 47 schematically shown in Figure 2. Data input buffer 47 includes a CMOS inverter 71 and a depression type N-type MOS transistor 72, the first terminal of which is coupled to the output terminal of inverter 71. The voltage Vcc is applied to the gate of transistor 72. Two N-type MOS transistors 73, 74 are coupled in series between the second terminal of MOS transistor 72 and power source Vcc. N-type MOS transistor 75 is arranged such that its source and drain terminals are coupled together. A pulse signal 0 is input thereto to substantially produce a capacitor-like operation. The gates of transistors 73 and 75 are coupled to a junction between series-coupled transistors 73 and 74. The gate of transistor 74 is connected to the second terminal of MOS transistor 72. The data input buffer constructed as described above has a voltage rising function using a pulse signal.

Figure 6 is a circuit diagram showing the detailed configuration of partial selector RD1 of the 8 partial selectors of selector 37 schematically shown in Figure 2. Partial selector RD1 has three P-type MOS transistors 81, 82, 83 coupled in parallel between power source Vcc and the input terminal of inverter 80. Three N-type MOS transistors 84, 85, 86 are coupled in series between the input terminal of inverter 80 and reference power source Vss. Bit A1 of the 3-bit row address input is input to the gates of transistors 81 and 84, A2 is input to the gates of transistors 82 and 85, and A3 is input to the gates of transistors 83 and 86. In partial selector RD1 constructed as described above, when the 3-bit address inputs A1, A2, A3 are all set to a high potential and the three N-type MOS transistors 84, 85, 86 are all turned on, the input terminal of inverter 80 is discharged to Vss. Thus, the output signal of inverter 80 becomes high level, thereby selecting the corresponding control line 38.

The remaining partial selectors of selector 37 are similarly constructed, but the 3-bit address inputs differ from those of RD1. Figure 7 illustrates the address inputs of the eight partial selectors RD1 to RD8.

The detailed operation of the memory constructed as described above will now be described. It should be understood that although the memory operations described below illustrate a particular sequence, the invention is not limited in this respect. Sequence as used herein refers to any predetermined order.

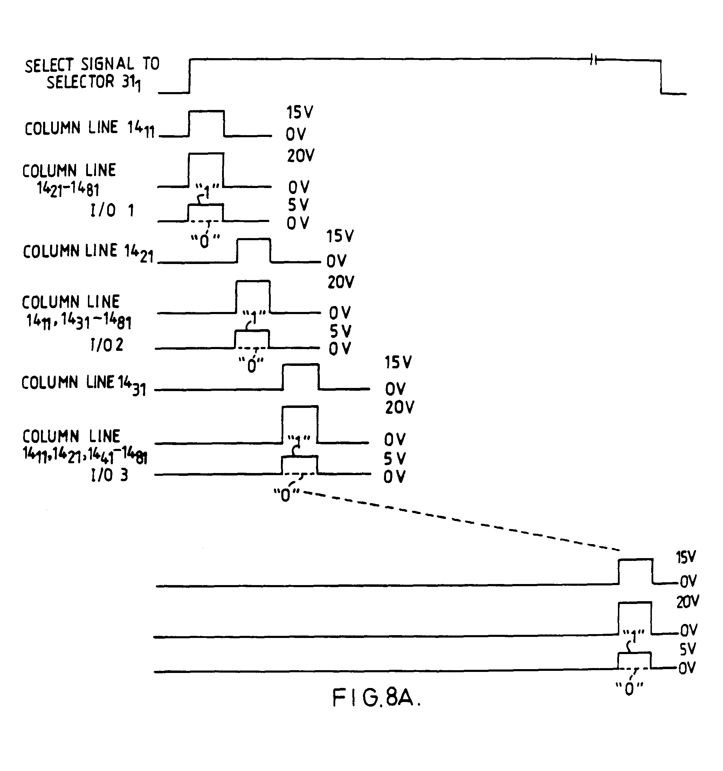

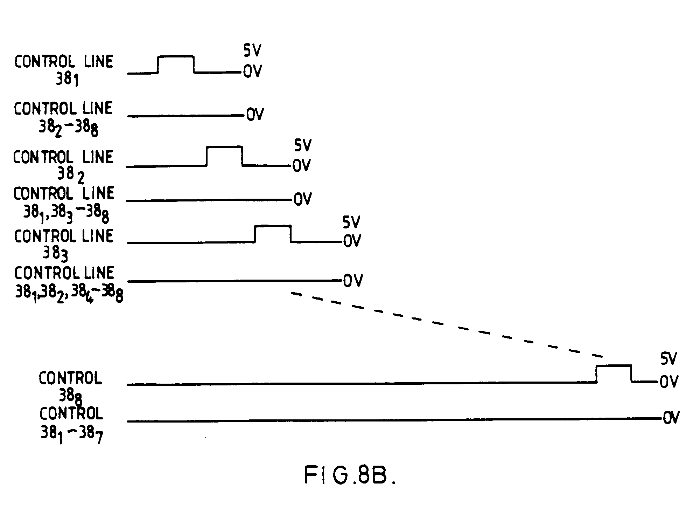

First, the operation of the memory during data writing will be described with reference to the timing charts of Figures 8A and 8B. Data is written by selecting one series circuit unit 10 and sequentially writing the data in the eight cells of the selected series circuit unit. Each cell of the selected series circuit unit is sequentially processed with a potential difference of 15 V imposed on the row line coupled to the control gate electrode of the cell being processed and a potential difference of 20 V imposed on the seven remaining row lines.

Suppose, for example, that the selected series circuit unit is coupled to bit line 12₁ and the eight row lines 14₁₁ to 14₈₁. A selection signal is output from row decoder 32 to series circuit selector 31₁, thereby selecting series circuit selector 31₁. In addition, a selection signal is output from column decoder 35 in column decoder/input-output circuit 30 to control line 36₁, and the eight transistors 43 whose gates are coupled to control line 36₁ are turned on. Then, data from second data lines 40₁ to 40₈ may be input to the eight latch circuits 41₁₁ to 41₈₁ disposed as shown in Figure 2. Under the control of the output of series circuit selector 31, a voltage of 15 V is imposed on row line 14₁₁ and a voltage of 20 V is imposed on the seven remaining row lines 41₂₁ to 41₈₁. At this time, all other row lines are maintained at 0 V. Under the control of selector 37, a voltage of 5 V is imposed on control line 38₁ and a voltage of 0 V is applied to the seven remaining control lines 38₂ to 38₈. Thus, the transistor 42 whose gate is coupled to control line 38₁ (maintained at 5V) is turned on, and the data latched in latch circuit 41₁₁ can be output to first data line 39₁. At this point, write data input from data input/output circuit 51₁ is transmitted to first data line 39₁ through second data line 40₁, transistor 43, latch circuit 41₁₁ and transistor 42. As noted above, signal R/W of control line 49 is set to a high potential during data writing, and thus transistors 45 and 48 are turned on. Write data transmitted to data line 39₁ may then be output to bit line 12₁ through data input buffer 47. The voltage of bit line 12 is maintained at one of two different voltages by the data input buffer 47 shown in Figure 5 in accordance with the data being written. When high-level data is written, it may be set to 10 V, for example, while when low-level data is written, it may be set to 0 V. At this time, all other bit lines are maintained at 0 V.

The seven memory cells 11 whose control gate electrodes are supplied with the voltage of 20 V operate as triodes (non-saturation operation). In this operation a channel region is formed between the source and drain regions, as shown in Figure 17.

The voltage between bit line 12₁ and ground line 13₁ is imposed across the source and drain of the selected cell, connected to column line 14₁₁. If bit line 12₁ is maintained at 10 V , electrons travel from the selected cell's source region to its drain region. A concentrated electric field, particularly in the depletion layer formed in the vicinity of the drain region, accelerates the electrons and imparts to them sufficient energy to cross the energy barrier of the insulating film from the surface of substrate 20, as shown in Figure 18. These electrons are called "hot electrons" and they are drawn to the selected cell's control gate electrode, which is set at the high voltage of 15 V . These hot electrons jump to and are captured by the floating gate electrode. As a result, the floating gate electrode of the selected cell becomes negatively charge and the threshold voltage rises to a high value.

If a voltage of 0 V is applied to bit line 12₁, the hot electrons are not generated and the threshold voltage remains in its original low state. Data may be written one cell at a time in this manner.

Next, output from series circuit selector 31 causes a voltage of 15 V to be imposed on row line 14₂₁ and a voltage of 20 V to be imposed on the seven remaining row lines. Likewise, output from selector 37 causes a voltage of 5 V to be imposed on control line 38₂ and 0 V to be imposed on the seven remaining control lines. Thus, the transistor 42, whose gate is coupled to control line 38₂ is turned on, and the data latched in latch circuit 41₂₁ may be output to first data line 39₁. At this time, data input from data input/output circuit 51₂(I/02) is transmitted to first data line 39₁ through second data line 40₂, transistor 43, latch circuit 41₂₁ and transistor 42. Thus, data may be written to the memory cell connected to row line 14₂₁. In a similar manner, data may be sequentially written to each of the remaining cells 11 in the selected series circuit unit 10.

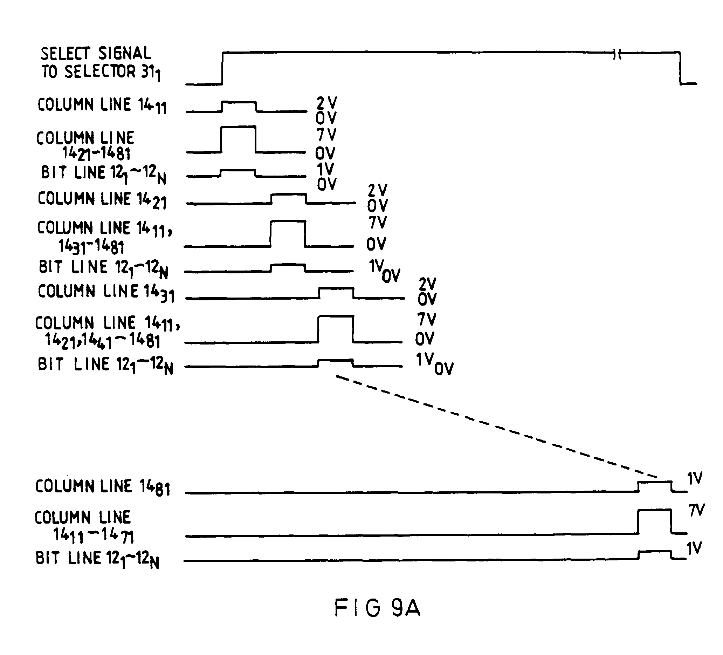

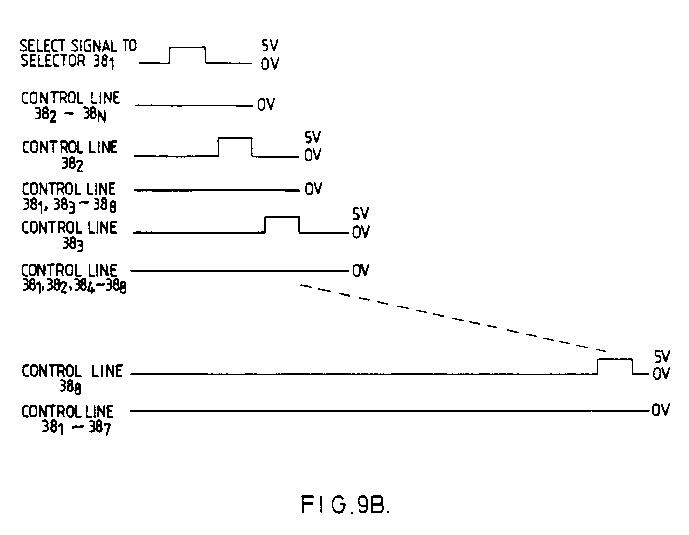

Next, the data reading operation will be described with reference to the timing charts of Figures 9A and 9B. During data reading, the N memory cells 11 disposed in a given row of memory cells are simultaneously selected for reading, the selected N cells being read in parallel. Under the control of a series circuit selector 31, a voltage of 2 V is applied to the row line coupled to the control gates of then selected cells, and a voltage of 7 V is applied to the seven remaining row lines. The other row lines are all maintained at 0 V.

Suppose, for example, the selected series circuit units are coupled to the eight row lines 14₁₁ to 14₈₁. A voltage of 2 V is initially applied only to row line 14₁₁, and a voltage of 7 V is applied to the seven remaining row lines 14₂₁ to 14₈₁. The threshold voltages of the selected memory cells 11 have been set in accordance with the data written to them during the data writing operation. The voltage of 2 V is, for example, higher than the low threshold voltage of those cells which have had data erased and lower than the high threshold voltage after high-level data is written. The voltage of 7 V is sufficiently higher than the high threshold voltage after high-level data is written. Therefore, applying the described voltages to the eight row lines 14₁₁ to 14₈₁ has the effect of turning on the memory cells whose control gate electrodes are coupled to the potential difference of 7 V, namely those cells on row lines 14₂₁-₈₁. However, the ON or OFF state of the selected cells whose control gate electrodes are coupled to column line 14₁₁, is determined by their threshold voltage, which as noted above, is set during the data write mode.

Sense amplifier 46 coupled to bit lines 12₁ to 12_{N} is activated during data reading, and the potential of the corresponding bit line 12 is set to the reading voltage, for example, of 1 V by sense amplifier 46. Cells in the row of memory cells which is being processed that have a low threshold voltage (i.e. have low-level data written therein) will be turned on by the voltage of row line 14₁₁ and thus the read voltage of the corresponding bit line 12 will be discharged to ground level line 13, through the corresponding series circuit unit. If, however, the cell has a high threshold voltage (i.e. has a high-level data written therein), it will remain off despite the imposition of the voltage of row lines 14₁₁ and the read voltage of the corresponding bit line 12 will not be discharged through the corresponding series circuit unit. Thus, the voltages of the N bit lines 12₁ to 12_{N} are dependent upon whether the threshold voltage of each of the selected cells is high or low, and amplification of these potential differences by sense amplifiers 46 makes it possible to determine whether high or low-level data is present on the associated bit line. Since signal R/W of signal line 49 is set to a low potential during data reading, the transistors 44 of Figure 2 are turned on. Thus, the reading data is amplified by sense amplifier 46 and then transmitted in parallel to the N first data lines 39₁ to 39_{N}.

Under the control of selector 37, a voltage of 5 V is applied to control line 38₁ and 0 V is applied to the seven remaining control lines. Thus, transistors 42 whose gates are coupled to control line 38₁ (maintained at 5 V), are turned on, and the N bits of data transmitted to first data lines 39₁ to 39_{N} are latched in parallel in latch circuits 41₁₁ to 41_{1N}, respectively.

Next, under the control of series circuit selector 31, a voltage of 2 V is applied to row line 14₂₁ and a voltage of 7 V is applied to the remaining seven row lines. Thus, data may be read from the N cells coupled to row line 14₂₁ in a manner similar to that described above, amplified by sense amplifiers 46, determined to be high- or low-level data, and transmitted to data lines 39₁ to 39_{N} respectively. Under the control of selector 37, a voltage of 5 V is applied to control line 38₂ and O V is applied to the seven remaining control lines. Thus, transistors 42, whose gates are coupled to control line 38₂ (maintained at 5 V), are turned on, and the data transmitted to the first data lines 39₁ to 39_{N} is latched in parallel in the N latch circuits 41₂₁ to 41_{2N} disposed in the same row. In a similar manner, data is sequentially read from the cells 11 in similarly processed N series circuit units 10, and transferred to latch circuits 41.

After eight bits (1 byte) of data from each of the series circuit units 10 in a given row of circuit units are latched in the latch circuits, a selection signal is output to control line 36₁ by the output of decoder 35, and the eight transistors 43, whose gates are coupled to control line 36₁, are turned on. Thus, the data latched in latch circuits 41₁₁ to 41₈₁, disposed as shown in Figure 2, are output in parallel to the eight second data lines 40₁ to 40₈, and output externally in parallel through data input/output circuits 51₁ to 51₈ (I/01 to I/08). Next, the selection signal is output to control line 36₂, and transistors 43, whose gates are coupled to control line 36₂, are turned on. Thus, the data latched in latch circuits 41₁₂ to 41₈₂ disposed as shown in Figure 2 , is output in parallel to second data lines 40₁ to 40₈, and output externally in parallel through data input/output circuits 51₁ to 51₈ (I/01 to I/08).

Thus, data stored in the memory cells is sequentially output in eight bit (1 byte) units. Data may be read out in parallel from N series circuit units 10 during data reading. The reading time required when the data is read into latch circuits 41 from series circuit units 10 according to the present invention can be shortened by a factor of 1/N a compared with the memory of the prior art. As a result, even through the data is read in parallel at 8-bit (1 byte) units only after it has been latched in latch circuits 41, the overall data reading rate can be accelerated.

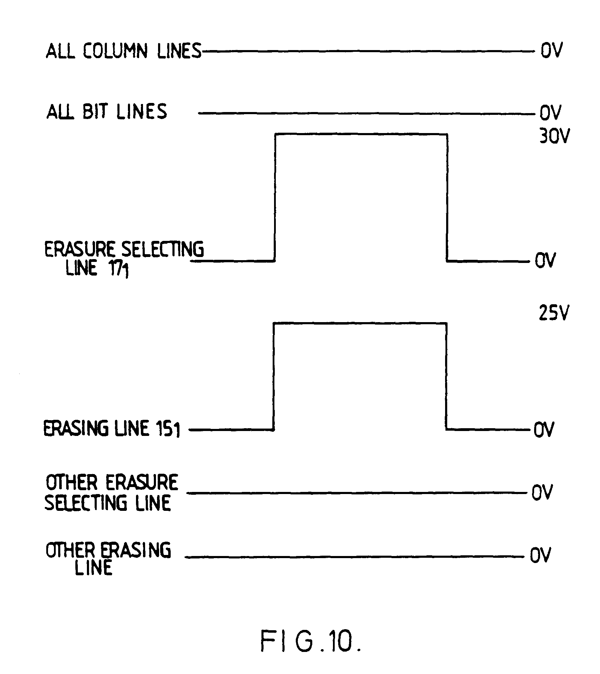

Finally, data erasure will be described with reference to the timing circuit of Figure 10. Each row line 14 and bit line 12 is maintained at 0 V during data erasure. A high voltage of 30 V is applied to the erase selecting line 17 coupled to the series circuit unit 10 to be erased. A high voltage of 25 V is applied to erase line 15 coupled to the series circuit unit 10 to be erased. In the example of Figure 10, the series circuit unit 10 to be erased is coupled to bit line 12₁ and the eight row lines 14₁₁ to 14₈₁. Thus, the transistors 16 coupled to the series circuit units 10 disposed in the same row containing the series circuit unit to be erased are turned on. The high voltage of erase line 15, however, is applied only to the common erase gate electrode of the series circuit unit 10 coupled to erase line 15, which is maintained at the high voltage of 25 V. Thus, an electric field emission occurs between the floating gate and erase gate electrodes of the eight cells 11 in the selected series circuit unit 10, and electrons stored in the floating gate electrodes are discharged to the erase gate electrodes. Consequently, the threshold voltages of the cells return to a low-level state, and eight bits of data are erased, i.e., byte erasure is effected.

It is also possible to effect erasure of the data stored in each memory bit simultaneously. In this instance, row decoder 32 and column decoder 35 may be configured so that a high voltage of 30 V is applied to each erase selecting line 17 and a high voltage of 25 V is applied to each erase line 15. Data may also be erased in bit line units.

Thus, the memory of the above-described embodiment permits reading and writing of data in units of 8 bits (1 byte) and electrical data erasure in byte units. Furthermore, one can look to large-scale integration, since the memory cell array includes only one non-volatile transistor for each memory cell. In contrast, conventional memories which permit electrical data erasure in byte units require each bit to comprise two or four transistors and are therefore unable to increase cell integration density. It is only possible to achieve a memory capacity of around 256 K bits in such a conventional memory. With the embodiment described above, however, since 1 bit comprises 1 transistor, it is possible to produce a memory with a degree of integration that is the same or better than that of the block erasure type memory illustrated in Figure 11. Specifically, the above-described embodiment requires the provision of one switching transistor for every eight memory cells 11 and therefore needs 1.125 transistors per bit, or 0.125 more transistors per bit than the memory of Figure 11. However, the block erasure type memory of Figure 11 requires formation of a contact for each bit, in order to connect cells to corresponding bit lines. The memory of the present embodiment only needs one contact for every eight cells and so permits an improvement in the degree of integration.

This invention is not limited to the embodiment described above but may be modified in a variety of ways. For example, although description was given above with reference to the case where data erasure is effected in byte units, it is also possible to effect block erasure of data from all cells, as in conventional memories, by the simultaneous imposition of a voltage of 30 V on all the erase selection lines 17 and a voltage of 25 V on all the erase lines 15 in data erasure.

Description was given with respect to the case where a read voltage of 1 V is imposed on bit lines 12 at times of data reading but it is preferable to make this read voltage as low as possible in order to suppress the phenomenon of so-called soft write (weak write-in occurring in read mode).

Further, although the electrodes 25 in Figure 13 that are used as cell control electrodes and column lines 14 were described as being made of polycrystalline silicon, they may also be made of a high melting point metal silicide, such as titanium silicide or molybdenum silicide, etc., or by another high melting point metal.

In the memory of the above-described embodiments, data can be erased in the multiple bit units, and data can be read at high speed in multiple bit units. Further, a memory cell array may be comprised of memory cells which comprise a single nonvolatile transistor, latch circuits 41 for use in reading data in parallel may be as many as N x 8, and those for an overhead may be extremely less as compared with the memory array section. Thus, the circuit of the memory of this embodiment, the memory cells can be highly integrated.

While the foregoing description is directed to a presently preferred embodiment, it will be obvious to one of ordinary skill that various modifications may be made without departing from the scope of the invention which is to be limited only by the appended claims.

While the number of series memory cells 11 has been shown in the embodiment of figure 1 as 8, this is not to be construed as limitative and other numbers may be so connected, for example, 4,16 or 32 memory cells may be connected (in general 2ⁿ, where n is an integer greater than or equal to one).

## Claims

1. A device for reading data from or writing data to a plurality of circuit units (10), each circuit unit (10) having a storing function, said circuit units (10) being disposed in a first matrix comprising a plurality of rows and columns, the device comprising:
a plurality of temporary storage cells (41); and
control means (37, 42, 44, 48) for addressing the temporary storage cells (41) and the circuit units (10) and controlling the transfer of data along data lines (12) between the temporary storage cells (41) and the circuit units (10), characterised in that each of said circuit units (10) comprises a plurality of memory cells (11) connected in series, and in that, the temporary storage cells (41) are disposed in a second matrix comprising a plurality of rows and columns;
the said data lines comprising a plurality of first data lines (12), a single of said first data lines (12) coupling the temporary storage cells (41) in a given column of said second matrix with the circuit units (10) in a given column of said first matrix; and
the control means comprising an address selector (31, 32, 35, 37, 42) including means for sequentially addressing the memory cells (11) in a selected circuit unit (10) in response to address data so as to transfer data between the memory cells (11) in said selected circuit unit (10) and the associated temporary storage cells (41) sequentially along the corresponding first data line (12).

2. A device according to claim 1, comprising second control means (35, 43) for controlling the transfer of data between the temporary storage cells (41) and an input/output means (51) for inputting data to and outputting data from said device.

3. A device according to Claim 1, wherein said control means for sequentially addressing said plurality of memory cells comprises:
a plurality of first switch means (42), a single of said first switch means (42) coupled between one of said temporary storage cells (41) and the corresponding first data line (12), the first switch means (42) associated with a given column of temporary storage cells (41) in said second matrix being activated in a predetermined sequence according to address data so as to effect the sequential transfer of data between the memory cells (11) in a given circuit unit (10) and the given column of temporary storage cells (41).

4. A device according to Claim 1, further comprising:
a plurality of sense amplifier means (46), a single of said sense amplifier means (46) being coupled to one of said first data lines (12) and adapted to amplify a voltage maintained on said first data line (12) to effect the reading of data in the memory cells (11) of a circuit unit (10) coupled to said first data line (12).

5. A device according to Claim 1, further comprising:
a plurality of data buffer means (47), a single of said data buffer means (47) coupled to one of said first data lines (12) and adapted to maintain predetermined voltages on said first data line (12) to effect the writing of data to the memory cells (11) of a circuit unit (10) coupled to said first data line.

6. A device according to Claim 1, further comprising:
a plurality of second data lines (40), a single of said second data lines (40) coupling the temporary storage cells (41) in a given row of said second matrix with input/output means (51) for inputting data to and outputting data from said device.

7. A device according to Claim 6, further comprising:
a plurality of second switch means (43), a single of said second switch means (43) being coupled between one of said temporary storage cells (41) and the corresponding second data line (40), said second switch means (43) being activated in a predetermined fashion so as to effect the transfer of data between said temporary storage cells (41) and said input/output means (51).

8. A device according to any preceding claim wherein said temporary storage cells comprise latch circuits.

9. A device according to Claim 1, wherein the number of temporary storage cells in each column of said second matrix is equal to the number of memory cells in a circuit unit.

10. A device according to any preceding claim, wherein each memory cell (11) comprises an electrically programmable non-volatile transistor.

11. A programmable semiconductor memory comprising a plurality of circuit units (10) each comprising a plurality of memory cells (11) connected in series, and a device according to any preceding claim connected thereto for reading or writing data from or to the memory cells.

12. A method of reading data from or writing data to a circuit unit (10) comprising at least two memory cells (11) connected in series, using a device according to any preceding claim, said method comprising the steps of:
sequentially addressing each memory cell (11) in said circuit unit so as to sequentially latch data stored in each memory cell into a corresponding one of said temporary storage cells; and outputting or inputting in parallel the latched data.

13. A method of reading data from or writing data to a plurality of circuit units (10), each circuit unit comprising at least two memory cells (11) connected in series, using a device according to any of Claims 1 to 11, said method comprising the steps of addressing at least one memory cell (11) in each of said plurality of circuit units; and simultaneously transferring data stored in the addressed memory cells in each circuit unit to respective temporary storage cells associated therewith.

14. A method according to Claim 13, further comprising the step of:
transferring data from the temporary storage cells associated with each circuit unit in parallel to an output device.

## Patentansprüche

1. Vorrichtung zum Auslesen und Einschreiben von Daten bei einer Vielzahl von Schaltungseinheiten (10), wobei jede Schaltungseinheit (10) eine Speicherungsfunktion hat, und die Schaltungseinheiten (10) in einer ersten Matrix angeordnet sind, die eine Vielzahl von Zeilen und Spalten aufweist, aufweisend:
eine Vielzahl von Zwischenspeicherungszellen (41); und
Steuermittel (37, 42, 44, 48), um die Zwischenspeicherungszellen (41) und die Schaltungseinheiten (10) zu adressieren, und den Transfer von Daten längs Datenleitungen (12) zwischen den Zwischenspeicherungszellen (41) und den Schaltungseinheiten (10) zu steuern, dadurch gekennzeichnet, daß jede der Schaltungseinheiten (10) eine Vielzahl von in Serie geschalteten Speicherzellen (11) aufweist, und daß die Zwischenspeicherungszellen (41) in einer zweiten Matrix angeordnet sind, die eine Vielzahl von Zeilen und Spalten aufweist;
die Datenleitungen eine Vielzahl von ersten Datenleitungen (12) aufweisen, wobei eine einzelne der ersten Datenleitungen (12) die Zwischenspeicherungszellen (41) in einer bestimmten Spalte der zweiten Matrix mit den Schaltungseinheiten (10) in einer bestimmten Spalte der ersten Matrix koppelt; und
die Steuermittel einen Adressenauswähler (31, 32, 35, 37, 42) aufweisen, der Mittel umfaßt, um die Speicherzellen (11) in einer ausgewählten Schaltungseinheit (10) als Reaktion auf Adreßdaten sequentiell zu adressieren, so daß Daten zwischen den Speicherzellen (11) in der ausgewählten Schaltungseinheit (10) und den zugeordneten Zwischenspeicherungszellen (41) sequentiell längs der entsprechenden ersten Datenleitung (12) transferiert werden.

2. Vorrichtung gemäß Anspruch 1, die zweite Steuermittel (35, 43) zum Steuern des Transfers von Daten zwischen den Zwischenspeicherungszellen (41) und einem Eingabe/Ausgabe-Mittel (51) aufweist, um Daten bei der Vorrichtung einzugeben und auszugeben.

3. Vorrichtung gemäß Anspruch 1, wobei die Steuermittel zum sequentiellen Adressieren der Vielzahl von Speicherzellen aufweisen:
eine Vielzahl von ersten Schaltmitteln (42), wobei ein einzelnes der ersten Schaltmittel (42) zwischen einer der Zwischenspeicherungszellen (41) und der entsprechenden ersten Datenleitung (12) angeordnet ist, und die ersten Schaltmittel (42), die einer bestimmten Spalte von Zwischenspeicherungszellen (41) der zweiten Matrix zugeordnet sind, in einer vorgegebenen Sequenz entsprechend Adreßdaten aktiviert werden, so daß der sequentielle Transfer von Daten zwischen den Speicherzellen (11) einer bestimmten Schaltungseinheit (10) und der bestimmten Spalte von Zwischenspeicherungszellen (41) ausgeführt wird.

4. Vorrichtung gemäß Anspruch 1, weiterhin aufweisend:
eine Vielzahl von Leseverstärkermitteln (46), wobei ein einzelnes der Leseverstärkermittel (46) mit einer der ersten Datenleitungen (12) gekoppelt ist, und ausgelegt ist, um eine auf der ersten Datenleitung (12) aufrechterhaltene Spannung zu verstärken, um das Lesen von Daten in den Speicherzellen (11) einer mit der ersten Datenleitung (12) gekoppelten Schaltungseinheit (10) auszuführen.

5. Vorrichtung gemäß Anspruch 1, weiterhin aufweisend:
eine Vielzahl von Datenpuffermitteln (47), wobei ein einzelnes der Datenpuffermittel (47) mit einer der ersten Datenleitungen (12) gekoppelt ist, und ausgelegt ist, um vorgegebene Spannungen auf der ersten Datenleitung (12) aufrechtzuerhalten, um das Schreiben von Daten bei den Speicherzellen (11) einer mit der ersten Datenleitung gekoppelten Schaltungseinheit (10) auszuführen.

6. Vorrichtung gemäß Anspruch 1, weiterhin aufweisend:
eine Vielzahl von zweiten Datenleitungen (40), wobei eine einzelne der zweiten Datenleitungen (40) die Zwischenspeicherungszellen (41) in einer bestimmten Zeile der zweiten Matrix mit Eingabe/Ausgabe-Mitteln (51) koppelt, um Daten bei der Vorrichtung einzugeben und auszugeben.

7. Vorrichtung gemäß Anspruch 6, weiterhin aufweisend:
eine Vielzahl von zweiten Schaltmitteln (43), wobei ein einzelnes der zweiten Schaltmittel (43) zwischen einer der Zwischenspeicherungszellen (41) und der entsprechenden zweiten Datenleitung (40) angeordnet ist, und die zweiten Schaltmittel (43) auf eine vorgegebene Weise aktiviert werden, so daß der Transfer von Daten zwischen den Zwischenspeicherungszellen (41) und den Eingabe/Ausgabe-Mitteln (51) ausgeführt wird.

8. Vorrichtung gemäß irgendeinem vorhergehenden Anspruch, wobei die Zwischenspeicherungszellen Verriegelungsschaltungen aufweisen.

9. Vorrichtung gemäß Anspruch 1, wobei die Anzahl der Zwischenspeicherungszellen in jeder Spalte der zweiten Matrix gleich der Anzahl der Speicherzellen einer Schaltungseinheit ist.

10. Vorrichtung gemäß irgendeinem vorhergehenden Anspruch, wobei jede Speicherzelle (11) einen elektrisch programmierbaren, nichtflüchtigen Transistor aufweist.

11. Programmierbarer Halbleiterspeicher, der eine Vielzahl von Schaltungseinheiten (10) aufweist, von denen jede eine Vielzahl von in Serie geschalteten Speicherzellen (11) aufweist, und damit verbundene Vorrichtung gemäß irgendeinem vorhergehenden Anspruch, um Daten bei den Speicherzellen auszulesen oder einzuschreiben.

12. Verfahren, um Daten bei einer Schaltungseinheit (10), die mindestens zwei in Serie geschaltete Speicherzellen (11) aufweist, auszulesen oder einzuschreiben, unter Verwendung einer Vorrichtung gemäß irgendeinem vorhergehenden Anspruch, wobei das Verfahren die Schritte aufweist, bei denen:
jede Speicherzelle (11) der Schaltungseinheit sequentiell adressiert wird, so daß in jeder Speicherzelle gespeicherte Daten in einer entsprechenden Zelle der Zwischenspeicherungszellen sequentiell verriegelt werden; und die verriegelten Daten parallel ausgegeben oder eingegeben werden.

13. Verfahren, um Daten bei einer Vielzahl von Schaltungseinheiten (10) auszulesen oder einzuschreiben, wobei jede Schaltungseinheit mindestens zwei in Serie geschaltete Speicherzellen (11) aufweist, unter Verwendung einer Vorrichtung gemäß irgendeinem der Ansprüche 1 bis 11, wobei das Verfahren die Schritte aufweist, bei denen mindestens eine Speicherzelle (11) in jeder der Vielzahl von Schaltungseinheiten adressiert wird; und gleichzeitig in den adressierten Speicherzellen jeder Schaltungseinheit gespeicherte Daten in zugeordnete Zwischenspeicherungszellen transferiert werden.

14. Verfahren gemäß Anspruch 13, das weiterhin den Schritt aufweist, bei dem:
Daten von den jeder Schaltungseinheit zugeordneten Zwischenspeicherungszellen parallel nach einer Ausgabevorrichtung transferiert werden.

## Revendications

1. Dispositif pour lire des données ou pour écrire des données dans un ensemble d'unités de circuit (10), chaque unité de circuit (10) ayant une fonction d'enregistrement, desdites unités de circuit (10) étant disposées en une première matrice comprenant un ensemble de rangées et de colonnes, le dispositif comprenant:
un ensemble de cellules d'enregistrement temporaire (41); et
des moyens de commande (37, 42, 44, 48) pour adresser les cellules d'enregistrement temporaire (41) et les unités de circuit (10), et pour commander le transfert de données sur des lignes de données (12) entre les cellules d'enregistrement temporaire (41) et les unités de circuit (10),
caractérisé en ce que chacune desdites unités de circuit (10) comprend un ensemble de cellules de mémoire (11) connectées en série, et en ce que les cellules d'enregistrement temporaire (41) sont disposées en une seconde matrice comprenant un ensemble de rangées et de colonnes;
lesdites lignes de données comprenant un ensemble de premières lignes de données (12), une seule desdites premières lignes de données (12) couplant les cellules d'enregistrement temporaire (41) dans une colonne donnée de la seconde matrice aux unités de circuit (10) dans une colonne donnée de la première matrice; et
les moyens de commande comprenant un sélecteur d'adresse (31, 32, 35, 37, 42) comprenant des moyens pour adresser séquentiellement les cellules de mémoire (11) dans une unité de circuit sélectionnée (10), sous la dépendance de données d'adresse, de façon à transférer des données entre les cellules de mémoire (11) dans l'unité de circuit (10) sélectionnée et les cellules d'enregistrement temporaire (41) associées, de manière séquentielle, sur la première ligne de données (12) correspondante.

2. Dispositif selon la revendication 1, comprenant des seconds moyens de commande (35, 43) pour commander le transfert de données entre les cellules d'enregistrement temporaire (41) et des moyens d'entrée/sortie (51) pour introduire des données dans le dispositif et pour émettre des données à partir de celui-ci.

3. Dispositif selon la revendication 1, dans lequel les moyens de commande pour adresser séquentiellement l'ensemble de cellules de mémoire comprennent:
un ensemble de premiers moyens de commutation (42), un seul desdits premiers moyens de commutation (42) étant couplé entre l'une desdites cellules d'enregistrement temporaire (41) et la première ligne de données (12) correspondante, le premier moyen de commutation (42) qui est associé à une colonne donnée de cellules d'enregistrement temporaire (41) dans la seconde matrice étant activé selon une séquence prédéterminée conformément à des données d'adresse, de façon à effectuer le transfert séquentiel de données entre les cellules de mémoire (11) dans une unité de circuit (10) donnée, et la colonne donnée de cellules d'enregistrement temporaire (41).

4. Dispositif selon la revendication 1, comprenant en outre:
un ensemble de moyens amplificateurs de lecture (46), un seul desdits moyens amplificateurs de lecture (46) étant couplé à l'une desdites premières lignes de données (12) et étant adapté pour amplifier une tension maintenue sur ladite première ligne de données (12), de façon à effectuer la lecture de données dans les cellules de mémoire (11) d'une unité de circuit (10) qui est couplée à ladite première ligne de données (12).

5. Dispositif selon la revendication 1, comprenant en outre:
un ensemble de moyens amplificateurs-séparateurs de données (47), un seul desdits moyens amplificateurs-séparateurs de données (47) étant couplé à l'une desdites premières lignes de données (12) et adapté de façon à maintenir des tensions prédéterminées sur ladite première ligne de données (12), pour effectuer l'écriture de données dans les cellules de mémoire (11) d'une unité de circuit (10) qui est couplée à ladite première ligne de données.

6. Dispositif selon la revendication 1, comprenant en outre:
un ensemble de secondes lignes de données (40), une seule desdites secondes lignes de données (40) couplant les cellules d'enregistrement temporaire (41) dans une rangée donnée de la seconde matrice à des moyens d'entrée/sortie (51) pour introduire des données dans le dispositif et pour émettre des données à partir de celui-ci.

7. Dispositif selon la revendication 6, comprenant en outre:
un ensemble de seconds moyens de commutation (43), un seul desdits seconds moyens de commutation (43) étant couplé entre l'une desdites cellules d'enregistrement temporaire (41) et la seconde ligne de données (40) correspondante, les seconds moyens de commutation (43) étant activés d'une manière prédéterminée de façon à effectuer le transfert de données entre les cellules d'enregistrement temporaire (41) et les moyens d'entrée/sortie (51).

8. Dispositif selon l'une quelconque des revendications précédentes, dans lequel les cellules d'enregistrement temporaire comprennent des circuits de bascule.

9. Dispositif selon la revendication 1, dans lequel le nombre de cellules d'enregistrement temporaire dans chaque colonne de la seconde matrice est égal au nombre de cellules de mémoire dans une unité de circuit.

10. Dispositif selon l'une quelconque des revendications précédentes, dans lequel chaque cellule de mémoire (11) comprend un transistor non volatil programmable de façon électrique.

11. Mémoire à semiconducteurs programmable comprenant un ensemble d'unités de circuit (10), comprenant chacune un ensemble de cellules de mémoire (11) connectées en série, et un dispositif selon l'une quelconque des revendications précédentes connecté à celles-ci, pour lire ou écrire des données dans les cellules de mémoire.

12. Procédé de lecture de données ou d'écriture de données dans une unité de circuit (10) comprenant au moins deux cellules de mémoire (11) connectées en série, en utilisant un dispositif selon l'une quelconque des revendications précédentes, ce procédé comprenant les étapes suivantes:
on adresse séquentiellement chaque cellule de mémoire (11) dans l'unité de circuit, de façon à mémoriser séquentiellement dans l'une correspondante des cellules d'enregistrement temporaire des données qui sont enregistrées dans chaque cellule de mémoire; et on émet ou on introduit en parallèle les données mémorisées.

13. Procédé de lecture de données ou d'écriture de données dans un ensemble d'unités de circuit (10), chaque unité de circuit comprenant au moins deux cellules de mémoire (11) connectées en série, en utilisant un dispositif selon l'une quelconque des revendications 1 à 11, ce procédé comprenant les étapes suivantes: on adresse au moins une cellule de mémoire (11) dans chaque unité de l'ensemble d'unités de circuit; et on transfère simultanément des données enregistrées dans les cellules de mémoire adressées, dans chaque unité de circuit, vers des cellules d'enregistrement temporaire respectives qui leur sont associées.

14. Procédé selon la revendication 13, comprenant en outre l'étape suivante:
on transfère des données, en parallèle, vers un dispositif de sortie, à partir des cellules d'enregistrement temporaire qui sont associées à chaque unité de circuit.
